# FASCICULE DE BREVET EUROPEEN

(11) **EP 0 589 732 B1**
(45) Date de publication et mention de la délivrance du brevet: **08.12.1999**
(21) Numéro de dépôt: 93402058.7
(22) Date de dépôt: 13.08.1993
(51) Int. Cl.: G06K 19/077, G06K 1/12

(54) **Procédé de marquage d'une carte à puce**
Chipkartemarkierungsverfahren
Chip card marking method

(30) Priorité: 26.08.1992 FR 9210296
(43) Date de publication de la demande: 30.03.1994
(73) Titulaire: GEMPLUS CARD INTERNATIONAL, F-13420 Gémenos (FR)
(72) Inventeur: Merlin, Pierre, F-75116 Paris (FR); Coiton, Gérard, F-75116 Paris (FR)
(74) Mandataire: Schmit, Christian Norbert Marie

(56) Documents cités:
- DE-A- 3 703 809
- FR-A- 2 207 459
- GB-A- 1 147 531
- GB-A- 2 240 948
- FEINWERKTECHNIK + MESSTECHNIK vol. 96, no. 7-8 , Juillet 1988 , MUENCHEN DE pages 308 - 310 TUMA 'BESCHRIFTEN MIT LASERSTRAHLEN'
- PATENT ABSTRACTS OF JAPAN vol. 9, no. 77 (M-369)(1800) 6 Avril 1985 & JP-A-59 207 246 (HITACHI)
- PATENT ABSTRACTS OF JAPAN vol. 7, no. 141 (M-223)(1286) 21 Juin 1983 & JP-A-58 053 444 (NIPPON DENKI)

## Description

La présente invention concerne un procédé de marquage d'indications sur un connecteur d'une carte dite à puce électronique, ledit connecteur présentant des contacts métalliques d'épaisseur donnée.

L'invention trouve une application particulièrement avantageuse dans le marquage des cartes à puce électronique, cartes bancaires ou télécartes par exemple, notamment pour y inscrire un message de sécurité ou une identification du fabricant.

D'une manière générale, les cartes à puce comportent des micro-modules qui se présentent sous la forme d'une bande-support en résine époxy portant, sur une face, le composant électronique (puce) proprement dit, et, sur une autre face, un connecteur électrique constitué par des contacts métalliques le plus souvent en cuivre recouvert d'une couche de nickel et d'une couche d'or. Les micromodules sont logés dans des cavités aménagées dans l'épaisseur de la carte de manière à laisser accessibles de l'extérieur lesdits contacts métalliques.

Actuellement, les micromodules ne portent aucune indication de quelque nature que ce soit, seule la raison sociale du fabricant apparait parfois sur la carte elle-même (voir GB-A-2240948). En particulier sur le plan sécurité, l'absence totale d'identification laisse la possibilité d'interchanger le micromodule et le corps de la carte.

Un certain nombre de méthodes pourraient être envisagées pour réaliser un marquage d'indications sur le micromodule, et plus précisément sur le connecteur dudit micromodule.

Le marquage par impression par exemple consisterait à déposer des couches d'encre sur les éléments métalliques du connecteur. Toutefois, ce procédé poserait deux problèmes, à savoir, d'une part, des contacts électriques dégradés du fait que les encres ne sont généralement pas conductrices, et, d'autre part, une certaine sensibilité à l'usure présentée par les gravures en relief.

La gravure mécanique serait incompatible avec un micromodule déjà assemblé à cause de la fragilité de la puce. De plus, il est quasi impossible d'imaginer une solution industrielle pour cette application.

La photogravure par voie chimique ne permet pas de contrôler l'attaque en profondeur, or il est impératif de ne pas entamer trop profondément le revêtement des contacts métalliques.

Quant à l'estampage, il ne peut être réalisé à un moment quelconque du processus de fabrication, ce qui donne peu de souplesse à cette technologie.

Aussi, le problème technique à résoudre par l'objet de la présente invention est de proposer un procédé de marquage d'indications sur un connecteur d'une carte dite à puce électronique, ledit connecteur présentant des contacts métalliques d'épaisseur donnée, procédé qui permettrait d'obtenir un marquage durable, sans dégradation au cours du temps, qui n'introduirait aucune perturbation dans le contact électrique et qui ne serait pas traumatisant pour la puce électronique elle-même, tout en restant d'une grande souplesse concernant notamment la place de l'opération de marquage dans le cycle de fabrication de la carte.

La solution au problème technique posé consiste, selon la présente invention, en ce que ledit procédé comporte une étape consistant à graver avec un faisceau laser lesdites indications dans l'épaisseur des contacts électriques du connecteur.

L'invention est spécifiée dans les revendications 1 et 12. Des modes de réalisation particuliers sont spécifiés dans les revendications dépendantes.

Ainsi, l'utilisation d'une gravure laser procure les avantages suivants :
- le message constitué par des indications gravées est indélébile,
- la finesse de la gravure évite d'altérer la fonction des contacts métalliques. Le revêtement n'est pas totalement retiré pour éviter d'exposer les contacts à la corrosion.
- il est possible d'insérer la gravure des indications à n'importe quel stade de la fabrication : sur le film de résine époxy avant la pose des puces, sur le film avec puces assemblées, sur micro-modules découpés ou encore sur les cartes elles-mêmes.

Conformément à un mode de mise en oeuvre particulier du procédé de marquage, objet de l'invention, il est prévu que pour graver on utilise un laser du type YAG, émettant dans l'infrarouge à la longueur d'onde de 1,06 µm. Dans ce cas, on balaye ledit faisceau laser sur le connecteur selon une trajectoire permettant de dessiner lesdites indications à marquer. Le métal est pulvérisé sous l'effet thermique, la maîtrise de la puissance du faisceau offrant la possibilité de limiter la profondeur de la gravure à une valeur très faible. Typiquement, la profondeur de la gravure sera réduite de façon à ne pas retirer la totalité du revêtement des contacts métalliques. Cette configuration autorise une très grande souplesse de programmation du message, par exemple identification unitaire.

Parmi les indications pouvant être marquées sur la carte, on peut citer une marque ou la raison sociale du fabricant ou encore une identification destinée à éviter tout acte de falsification. Dans ce dernier cas, l'invention prévoit que :
- on reconnait des indications d'identification mémorisées dans ladite puce,
- on marque sur le connecteur lesdites indications d'identification,
- on marque également sur la carte les indications d'identification.

La description qui va suivre en regard des dessins annexés, donnés à titre d'exemples non limitatifs, fera bien comprendre en quoi consiste l'invention et comment elle peut être réalisée.

La figure 1 est une vue en coupe d'un micromodule de carte à puce électronique.

La figure 2 est une vue de dessus correspondant à la vue en coupe de la figure 1.

La figure 3 est une vue schématique en perspective d'un dispositif de marquage mettant en oeuvre le procédé de l'invention à l'aide d'un laser de type YAG.

La figure 4 est une vue schématique en coupe d'un dispositif de marquage mettant en oeuvre le procédé de l'invention à l'aide d'un laser à excimère.

La figure 5 est une vue en coupe d'un contact métallique après marquage selon le procédé de l'invention.

La figure 6 est un diagramme d'un dispositif de marquage programmé mettant en oeuvre le procédé de l'invention.

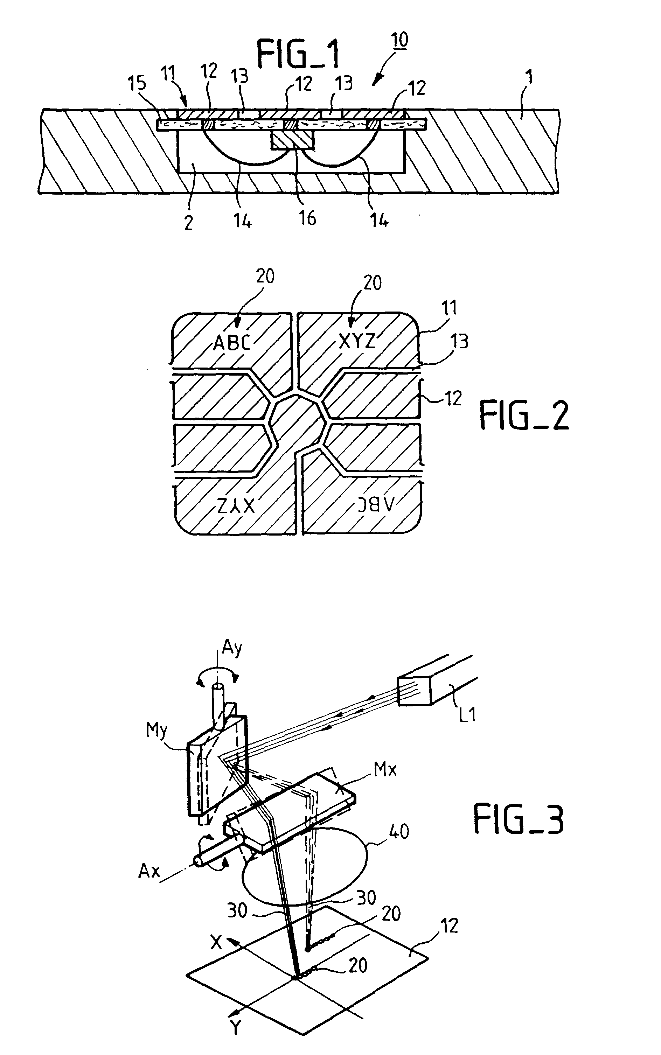

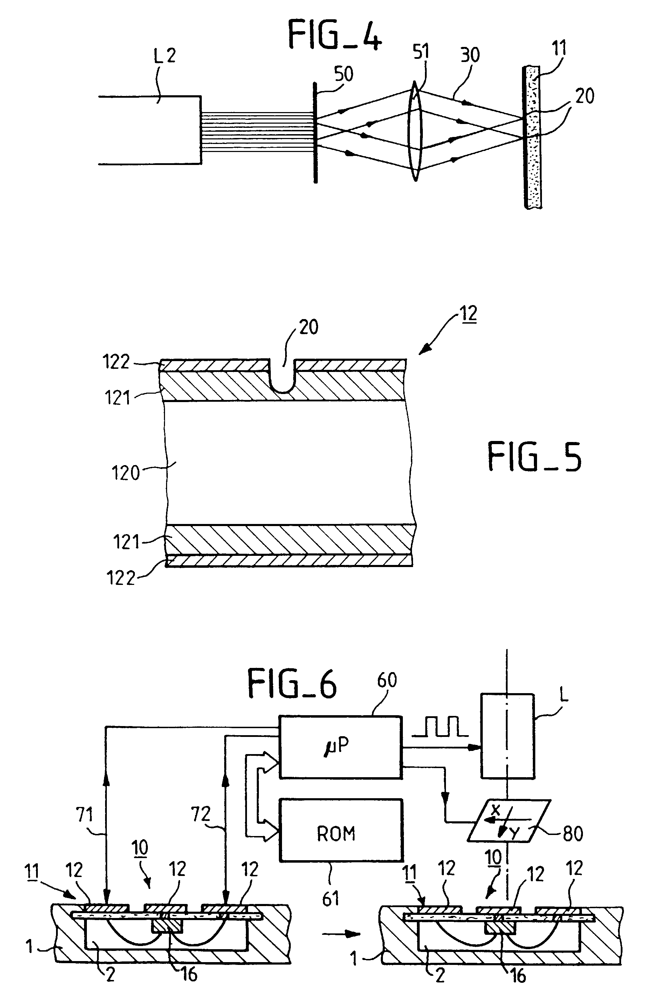

La figure 1 montre en coupe un micromodule 10 placé à l'intérieur d'une cavité 2 aménagée dans le corps d'une carte 1 dite à puce électronique. Ce micromodule 10 comporte un connecteur 11 constitué par un ensemble de contacts métalliques 12 déposés sur un support 15 en résine époxy. Les divers contacts métalliques 12 sont séparés les uns des autres par des lignes 13 d'isolement, et reliés à un composant électronique 16, la puce proprement dite, par des fils conducteurs 14. Comme le montre la figure 5, les contacts métalliques 12 peuvent être composés d'une couche principale 120 de cuivre d'une épaisseur de 70 µm environ revêtue de part et d'autre d'une couche 121 de nickel de 1 µm et d'une couche 122 d'or de 0,1 µm. Le revêtement de la couche 120 de cuivre par du nickel et de l'or permet notamment d'éviter la corrosion du cuivre au contact de l'atmosphère ambiante.

Les figures 3 et 4 représentent de manière schématique deux dispositifs pour la mise en oeuvre d'un procédé de marquage d'indications, référencées 20 sur les figures 2, 3 et 4, sur le connecteur 11 de la carte 1 à puce électronique, procédé comportant une étape consistant à graver avec un faisceau laser 30 lesdites indications 20 dans l'épaisseur des contacts métalliques 12 du connecteur 11.

Sur la figure 3, le faisceau laser 30 de gravure provient d'un laser L1 de type YAG émettant un rayonnement infra-rouge à 1,06 µm de longueur d'onde. Le faisceau laser 30 est focalisé sur les contacts métalliques 12 par une lentille 40 formant dans son plan focal un point image qui peut avoir 70 µm de diamètre. la gravure est obtenue par balayage, avec par exemple un recouvrememnt de 10 à 30 µm entre points image successifs, dudit faisceau laser 30 sur le connecteur 11 selon une trajectoire permettant de dessiner lesdites indications à marquer. Dans le dispositif montré sur la figure 3, le balayage est effectué à l'aide de deux miroirs de renvoi Mx, My pivotant respectivement autour de deux axes Ax et Ay orthogonaux. Bien entendu, les rotations des miroirs Mx et My ainsi que leur synchronisation peuvent être commandées numériquement à partir des indications 20 à marquer.

Le dispositif de la figure 4 utilise un laser à excimére L2 émettant un rayonnement ultra-violet à la longueur d'onde de 308 nm par exemple. Une image d'un masque 50 perforé selon un dessin correspondant aux indications 20 à marquer est formée sur le connecteur 11 par l'intermédiaire d'une lentille 51.

La puissance du faisceau laser utilisé doit être parfaitement contrôlée de façon à ce que, comme l'indique la figure 5, la profondeur des indications 20 gravées n'entame pas la couche de cuivre 120, mais reste localisée au niveau des couches supérieures 121, 122 de nickel et d'or, ceci afin d'éviter la corrosion des contacts. Dans ce but, il est prévu par exemple d'utiliser un dispositif continu et de moduler ledit faisceau laser afin de limiter la puissance de gravure. Cette modulation peut être réalisée en hachant l'alimentation du laser L, ainsi que le montre la figure 6. Il est bien entendu toutefois que d'autres moyens peuvent être mis en oeuvre pour moduler le faisceau laser, tels que les modulateurs électroopiques à effet Kerr ou effet Pockels.

Afin de régler la puissance de gravure en fonction de l'épaisseur des contacts métalliques 12, on peut modifier alors le rapport cyclique de la modulation. La figure 6 montre que cette opération de réglage peut être exécutée automatiquement par un microprocesseur 60 commandé par un programme de travail stocké dans une mémoire morte 61.

Naturellement, l'étape de gravure des contacts métalliques 12 du connecteur 11 peut être effectuée à un stade quelconque de l'élaboration de la carte 1. En particulier, on peut prévoir que, préalablement à ladite étape de gravure, on réalise le micromodule 10 comportant ledit connecteur et la puce électronique 16 associée. En effet, le procédé de marquage conforme à l'invention étant sans danger vis à vis de la puce elle-même, il est permis d'envisager sa mise en oeuvre même à un stade avancé de la fabrication de la carte.

La figure 6 montre que l'on peut même effectuer l'étape de gravure après que le micromodule 10 ait été monté sur le corps de la carte 1. On peut voir également sur la figure 6 que, dans ce cas, il possible, à l'aide de palpeurs 71, 72, de reconnaitre des indications d'identification à marquer inscrites électriquement dans la puce 16 et de les transmettre au microprocesseur 60 qui, outre la modulation du laser L, commande des moyens 80 de balayage en x et y du faisceau laser 30 en fonction des indications reçues. Ces indications d'identification peuvent ainsi être gravées aussi bien sur les contacts métalliques 12 du micromodule 10 que sur le corps même de la carte 1, réalisant de la sorte un moyen de sécurité permettant d'éviter d'interchanger micromodule 10 et carte 1.

## Revendications

1. Procédé de marquage d'indications (20) sur un connecteur (11) d'une carte (1) dite à puce électronique (16) ledit connecteur présentant des contacts métalliques (12) d'épaisseur donnée, ledit procédé comportant une étape consistant à graver avec un faisceau laser (30) lesdites indications dans l'épaisseur des contacts métalliques (12) du connecteur (11), la puissance dudit faisceau laser (30) étant contrôlée de manière à limiter la profondeur de gravure en fonction de l'épaisseur desdits contacts métalliques (12).

2. Procédé selon la revendication 1, caractérisé en ce que, préalablement à l'étape de gravure, on réalise un micromodule (10) comportant ledit connecteur (11) et la puce électronique (16) associée.

3. Procédé selon l'une des revendications 1 ou 2, caractérisé en ce que pour graver on utilise un laser (L1) du type YAG.

4. Procédé selon l'une des revendications 1 ou 2, caractérisé en ce que pour graver on utilise un laser (L2) à excimère.

5. Procédé selon l'une quelconque des revendications 1 à 4, caractérisé en ce que pour graver on balaye ledit faisceau laser (30) sur le connecteur (11) selon une trajectoire permettant de dessiner lesdites indications (20) à marquer.

6. Procédé selon l'une quelconque des revendications 1 ou 4, caractérisé en ce que pour graver on forme sur le connecteur (11) avec ledit faisceau laser (30) une image d'un masque (50) perforé selon un dessin correspondant aux indications (20) à marquer.

7. Procédé selon l'une quelconque des revendications 1 à 6, caractérisé en ce que pour graver :
- on utilise un dispositif susceptible d'émettre un faisceau laser de manière continu,
- on module ledit faisceau laser afin de limiter la puissance de gravure.

8. Procédé selon la revendication 7, caractérisé en ce que pour moduler on modifie le rapport cyclique de modulation afin de régler la puissance de gravure en fonction de l'épaisseur des contacts métalliques (12) du connecteur (11).

9. Procédé selon l'une quelconque des revendications 2 à 8, caractérisé en ce que :
- on fixe le micromodule (10) sur la carte (1) avant le marquage, puis
- on marque lesdites indications (20) sur le connecteur (11) du micromodule (10),

10. Procédé selon l'une quelconque des revendications 1 à 9, caractérisé en ce que :
- on reconnait des indications (20) d'identification inscrites dans ladite puce (16),
- on marque sur le connecteur (11) lesdites indications d'identification.

11. Procédé selon la revendication 10, caractérisé en ce qu'on marque également sur la carte (1) les indications (20) d'identification.

12. Connecteur d'une carte (1) dite à puce électronique (16) présentant des contacts métalliques (12) d'épaisseur donnée, lesdits contacts comportant des indications marquées selon le procédé de l'une des revendications 1 à 11.

13. Carte dite à puce électronique comportant un connecteur selon la revendication 12.

## Patentansprüche

1. Verfahren zur Markierung von Angaben (29) auf einem Verbinder (11) einer sogenannten elektronischen Chipkarte (1), wobei der Verbinder Metallkontakte (12) gegebener Dicke hat, und wobei das Verfahren einen Schritt umfaßt, der darin besteht, mit einem Laserstrahl (30) die Angaben in die Dicke der Metallkontakte (12) des Verbinders (11) zu gravieren, wobei die Leistung des Laserstrahls (30) so gesteuert wird, daß die Graviertiefe abhängig von der Dicke der Metallkontakte (12) begrenzt wird.

2. Verfahren nach Anspruch 1, dadurch gekennzeichnet, daß man vor dem Gravierschritt ein Mikromodul (10) verwirklicht, welches den Verbinder (11) und den zugehörigen elektronischen Chip (16) umfaßt.

3. Verfahren nach einem der Ansprüche 1 oder 2, dadurch gekennzeichnet, daß man zum Gravieren einen Laser (L1) vom Typ YAG verwendet.

4. Verfahren nach einem der Ansprüche 1 oder 2, dadurch gekennzeichnet, daß man zum Gravieren einen Excimer-Laser (L2) verwendet.

5. Verfahren nach einem der Ansprüche 1 bis 4, dadurch gekennzeichnet, daß man zum Gravieren den Verbinder (11) mit dem Laserstrahl (30) gemäß einer Bahn abtastet, die es gestattet, die zu markierenden Angaben (20) zu zeichnen.

6. Verfahren nach einem der Ansprüche 1 bis 4, dadurch gekennzeichnet, daß man zur Gravierung auf dem Verbinder (11) mit dem Laserstrahl (30) die Abbildung einer perforierten Maske (50) bildet, gemäß einer Zeichnung, welche den zu markierenden Angaben (20) entspricht.

7. Verfahren nach einem der Ansprüche 1 bis 6, dadurch gekennzeichnet, daß man zum Gravieren:
- eine Vorrichtung verwendet, welche auf kontinuierliche Weise einen Laserstrahl ausgibt;
- der Laserstrahl moduliert wird, um die Gravierleistung zu begrenzen.

8. Verfahren nach Anspruch 7, dadurch gekennzeichnet, daß man zum Modulieren das Schaltverhältnis der Modulation modifiziert, um die Gravierleistung abhängig von der Dicke der Metallkontakte (12) des Verbinders (11) zu regeln.

9. Verfahren nach einem der Ansprüche 2 bis 8, dadurch gekennzeichnet, daß man:
- das Mikromodul (10) auf der Karte (1) vor der Markierung fixiert, und danach
- die Angaben (20) auf dem Verbinder (11) des Mikromoduls (10) markiert.

10. Verfahren nach einem der Ansprüche 1 bis 9, dadurch gekennzeichnet, daß man:
- die Identifikationsangaben (20), die in dem Chip (16) geschrieben sind, erkennt;
- auf dem Verbinder (11) die Identifikationsangaben markiert.

11. Verfahren nach Anspruch 10, dadurch gekennzeichnet, daß man die Identifikationsangaben (20) auch auf der Karte (1) markiert.

12. Verbinder einer sogenannten elektronischen Chipkarte (1), welcher Metallkontakte (12) gegebener Dicke hat, wobei die Kontakte markierte Angaben nach dem Verfahren einer der Ansprüche 1 bis 11 umfassen.

13. Elektronische Chipkarte umfassend einen Verbinder nach Anspruch 12.

## Claims

1. Process for marking information (20) on a connector (11) of a so-called smart card (1) with an electronic chip (16), said connector exhibiting metal contacts (12) of given thickness, said process comprising a stage consisting in etching said information in the thickness of the metal contacts (12) of the connector (11) with a laser beam (30), the power of said laser beam (30) being controlled so as to limit the depth of etching according to the thickness of said metal contacts (12).

2. Process according to claim 1, characterised in that, prior to the etching stage, a micromodule (10) is produced comprising said connector (11) and the associated electronic chip (16).

3. Process according to one of claims 1 or 2, characterised in that a type YAG laser (L1) is used for etching.

4. Process according to one of claims 1 or 2, characterised in that an excimer laser (L2) is used for etching.

5. Process according to any one of claims 1 to 4, characterised in that for etching said laser beam (30) is swept over the connector (11) along a path permitting drawing of said information (20) to be marked.

6. Process according to any one of claims 1 or 4, characterised in that for etching an image of a mask (50) perforated according to a drawing corresponding to the information (20) to be marked is formed on the connector (11) with said laser beam (30).

7. Process according to any one of claims 1 to 6, characterised in that for etching
- a device capable of emitting a laser beam continuously is used,
- said laser beam is modulated in order to limit the etching power.

8. Process according to claim 7, characterised in that for modulation the cyclic modulation ratio is modified in order to control the etching power according to the thickness of the metal contacts (12) of the connector (11).

9. Process according to any one of claims 2 to 8, characterised in that
- the micromodule (10) is fixed on the card (1) before the marking, then
- said information (20) is marked on the connector (11) of the micromodule (10).

10. Process according to any one of claims 1 to 9, characterised in that
- information (20) for identification written in said chip (16) is recognised,
- said information for identification is marked on the connector (11).

11. Process according to claim 10, characterised in that the information (20) for identification is also marked on the card (1).

12. Connector of a so-called smart card (1) with an electronic chip (16) exhibiting metal contacts (12) of given thickness, said contacts comprising information marked according to the process of one of claims 1 to 11.

13. So-called smart card with an electronic chip comprising a connector according to claim 12.
